# EUROPÄISCHE PATENTANMELDUNG

(11) **EP 3 606 304 A1**
(43) Veröffentlichungstag der Anmeldung: **05.02.2020**
(21) Anmeldenummer: 18186287.1
(22) Anmeldetag: 30.07.2018
(51) Int. Cl.: H05K 7/20

(54) **MODULARER STROMRICHTER**

(71) Anmelder: Siemens Aktiengesellschaft, 80333 München (DE)
(72) Erfinder: Brendel, Bernd, 96114 Hirschaid (DE); Helsper, Martin, 90584 Allersberg (DE); Martin, Stephan, 90574 Roßtal (DE); Schimana, Martin, 90408 Nürnberg (DE)

(57) **Zusammenfassung**

Die Erfindung betrifft ein Stromrichtermodul (1) mit einem dreiphasigen Wechselrichter und einem Kühlsystem zum Kühlen mit einer Kühlflüssigkeit, wobei das Kühlsystem einen Kanal (2) zum Führen der Kühlflüssigkeit aufweist. Zur Verbesserung der Modularität des flüssigkeitsgekühlten Stromrichters wird vorgeschlagen, dass das Stromrichtermodul (1) ein Gehäuse (3) aufweist und der dreiphasige Wechselrichter im Innern des Gehäuses (3) angeordnet ist, wobei das Gehäuse (3) eine erste Oberfläche (31) aufweist, an der ein DC/DC Steller (4) kontaktierbar ist, wobei der Kanal (2) zum Führen der Kühlflüssigkeit sich derart entlang der ersten Oberfläche (31) erstreckt, dass die erste Oberfläche (31) durch die Kühlflüssigkeit kühlbar ist. Ferner betrifft die Erfindung einen modularen Stromrichter (10) mit einem derartigen Stromrichtermodul (1) und einem DC/DC Steller (4), wobei der DC/DC Steller (4) an der ersten Oberfläche (31) des Stromrichtermoduls (1) angeordnet ist. Die Erfindung betrifft weiter ein Fahrzeug (20) mit einem derartigen Stromrichtermodul (1) oder einem derartigen modularen Stromrichter (10), wobei das Stromrichtermodul (1) oder der modulare Stromrichter (10) ein Teil des Antriebs des Fahrzeugs (20) ist. Weiter betrifft die Erfindung ein Verfahren zum Kühlen eines derartigen modularen Stromrichters (10), wobei die Wärme des DC/DC Stellers (4) über die erste Oberfläche (31) des Stromrichtermoduls (1) an die Kühlflüssigkeit des Kühlsystems des Stromrichtermoduls (1) abgeführt wird.

## Beschreibung

Die Erfindung betrifft ein Stromrichtermodul mit einem dreiphasigen Wechselrichter und einem Kühlsystem zum Kühlen mit einer Kühlflüssigkeit, wobei das Kühlsystem einen Kanal zum Führen der Kühlflüssigkeit aufweist. Weiter betrifft die Erfindung einen modularen Stromrichter mit einem derartigen Stromrichtermodul. Die Erfindung betrifft weiter ein Fahrzeug mit einem derartigen Stromrichtermodul oder einem derartigen modularen Stromrichter. Ferner betrifft die Erfindung ein Verfahren zum Kühlen eines derartigen modularen Stromrichters.

Stromrichter für die Energieverteilung in elektrischen Antrieben von Bussen, insbesondere Stadtbussen, und Nutzfahrzeugen müssen verschiedene Funktionen erfüllen. Je nach Topologie und Einsatzzweck arbeiten sie als Gleichrichter, Wechselrichter, Gleichspannungswandler oder 3-phasiger Kurzschließer. Diese Funktionen werden jedoch nicht in jeder Anwendung gleichzeitig benötigt. Bisherige Lösungen realisieren diese Funktionen durch den Einsatz von unterschiedlichen Vorrichtungen bzw. Stromrichtern oder es gibt Stromrichter, welche in einem universellen Gerät durch wahlweise Bestückung die geforderten Funktionen realisieren. Dabei muss das Gerät aber immer für den gesamten Funktionsumfang ausgelegt sein.

Bisher kommen Stromrichtereinrichtungen zum Einsatz, die in einer universellen konstruktiven Ausführung verschiedene Funktionen kombinieren. Heute sind Stromrichter bekannt, die in einem Gehäuse die Funktionen Wechselrichter bzw. Gleichrichter, DC/DC-Steller und 3-phasiger Kurzschließer gleichzeitig realisieren können. Dabei weist die Konstruktion einen Ansatz auf, der alle Funktionen gleichzeitig integrieren kann. Bei Bedarf kann man durch Minderbestückung Teile von Vorrichtungen wie DC/DC-Steller oder Kurzschließer weglassen. Andere konstruktive Teile sind aber trotzdem vorhanden, so dass eine Minderbestückung nur zu einem mäßig reduzierten Aufwand führt. Auch eine Platzersparnis lässt sich damit nicht erreichen. Für den Kunden ergeben sich somit in Bezug auf die Maße des Gerätes keine Vorteile.

Eine andere bekannte Ausführung ist eine Stromrichtereinrichtung mit reduzierter Funktionalität. Hier kann entweder eine Wechselrichterfunktion oder eine DC/DC-Steller Funktion realisiert werden. Darüber hinaus ist auch die Realisierung einer Kurzschließerfunktion nicht möglich.

Der Erfindung liegt die Aufgabe zugrunde, einen flüssigkeitsgekühlten Stromrichter hinsichtlich seiner Modularität zu verbessern.

Diese Aufgabe wird durch ein Stromrichtermodul mit einem dreiphasigen Wechselrichter und einem Kühlsystem zum Kühlen mit einer Kühlflüssigkeit gelöst, wobei das Kühlsystem einen Kanal zum Führen der Kühlflüssigkeit aufweist, wobei das Stromrichtermodul ein Gehäuse aufweist und der dreiphasige Wechselrichter im Innern des Gehäuses angeordnet ist, wobei das Gehäuse eine erste Oberfläche aufweist, an der ein DC/DC Steller kontaktierbar ist, wobei der Kanal zum Führen der Kühlflüssigkeit sich derart entlang der ersten Oberfläche erstreckt, dass die erste Oberfläche durch die Kühlflüssigkeit kühlbar ist. Ferner wird die Aufgabe durch einen modularen Stromrichter mit einem derartigen Stromrichtermodul und einem DC/DC Steller gelöst, wobei der DC/DC Steller an der ersten Oberfläche des Stromrichtermoduls angeordnet ist. Die Aufgabe wird weiter durch ein Fahrzeug mit einem derartigen Stromrichtermodul oder einem derartigen modularen Stromrichter gelöst, wobei das Stromrichtermodul oder der modulare Stromrichter ein Teil des Antriebs des Fahrzeugs ist. Weiter wird die Aufgabe durch ein Verfahren zum Kühlen eines derartigen modularen Stromrichters gelöst, wobei die Wärme eines DC/DC Stellers über die erste Oberfläche des Stromrichtermoduls an die Kühlflüssigkeit des Kühlsystems des Stromrichtermoduls abgeführt wird.

Weitere vorteilhafte Ausgestaltungen der Erfindung sind in den abhängigen Ansprüchen angegeben.

Der Erfindung liegt die Erkenntnis zugrunde, dass sich die Modularität eines Stromrichters dadurch verbessern lässt, wenn man das Stromrichtermodul als Grundgerät mit einem Gehäuse ausführt. Der Wechselrichter ist in diesem Gehäuse angeordnet und wird mit Hilfe eines Kühlsystems gekühlt. Die Notwendigkeit der Kühlung ergibt sich aus der im Betrieb des Wechselrichters entstehenden Wärme. Dabei entsteht die Wärme größtenteils in den Halbleitern des Wechselrichters. Das Gehäuse richtet sich nach den Bedürfnissen des Wechselrichters und ggf. nach seiner Kühlung. Dazu gehören beispielsweise auch die Steuerung/Regelung und die Eigenversorgung mit elektrischer Energie. Dadurch kann das Gehäuse besonders kompakt ausgeführt sein. Erweiterungen, wie ein DC/DC Steller können dann als weitere modulare Komponente an das Gehäuse montiert werden. Der DC/DC Steller kann dabei beispielsweise zur Ansteuerung eines Bremswiderstandes oder zur Verbindung mit einem Energiespeicher verwendet werden. Um die Komplexität dabei gering zu halten, wird die Kühlung des DC/DC Stellers über das Stromrichtermodul vorgenommen. Dadurch entfallen Kühlanschlüsse für einen erweiterten Flüssigkeitskreislauf durch den DC/DC Steller. Es hat sich gezeigt, dass es für die Leistungsfähigkeit der Kühlung hinreichend ist, wenn sich der DC/DC Steller über das Gehäuse des Stromrichtermoduls entwärmt und damit die im Betrieb des DC/DC Stellers entstehende Wärme über das Gehäuse des Stromrichtermoduls an die Kühlflüssigkeit des Kühlsystem überträgt. Dazu wird die Kühlflüssigkeit über einen oder mehrere, d.h. mindestens zwei, Kanäle in die Umgebung der ersten Oberfläche geführt. Dieser Kanal erstreckt sich für einen guten Wärmeübergang von der ersten Oberfläche zum Kühlmittel zumindest abschnittsweise entlang dieser ersten Oberfläche. Insbesondere eine mäanderförmige Anordnung entlang der ersten Oberfläche hat sich als günstig erwiesen, die im Betrieb des DC/DC Stellers entstehenden Verluste an die Kühlflüssigkeit des Kühlsystems wirkungsvoll abzugeben. Besonders vorteilhaft ist es, wenn der Abstand zwischen Kanal und erster Oberfläche abschnittsweise geringer ist als ein Zentimeter (1cm).

Durch den Wegfall der Kühlanschlüsse für den DC/DC Steller lässt sich der modulare Stromrichter auf einfache Weise aus einzelnen Modulen aufbauen, und die Schnittstellen zwischen den einzelnen Modulen minimieren. Dies macht den modularen Stromrichter kostengünstig und einfach montierbar. Der Platz, den der modulare Stromrichter einnimmt, ist bei einer Minderbestückung deutlich geringer als bei bereits bekannten Lösungen. Darüber hinaus besteht bei dem Kühlsystem mit einer Flüssigkeitskühlung immer die Gefahr einer Leckage, bei der austretende Kühlflüssigkeit den Stromrichter beschädigt und damit zu Ausfall des Antriebs führen kann. Gerade die Kühlanschlüsse gelten dabei als kritische Stelle, an denen Undichtigkeiten auftreten können. Somit kann durch den vorgeschlagenen Aufbau auch die Zuverlässigkeit des modularen Stromrichters deutlich erhöht werden.

Durch die Erfindung der modularen Stromrichtereinrichtung wird der Einsatz mehrere Stromrichter bzw. der Einsatz eines aufwendigen universellen Gerätes dadurch vermieden, dass je nach Anforderung verschiedene Stromrichtervorrichtungen modular zu einer Stromrichtereinrichtung kombiniert werden. Dadurch entsteht für den Kunden eine Stromrichtereinheit, welche genau auf den geforderten Funktionsumfang zugeschnitten ist. Das heißt, dass auch bei der Realisierung mit mehreren Funktionen wie DC/DC Steller und/oder Kurzschließer der modulare Stromrichter erweitert wird und sich nicht auf mehrere Geräte aufteilt. Das Wiederum spart Schnittstellen und erhöht darüber hinaus die Zuverlässigkeit des Stromrichters, die gerade für die Traktion von Fahrzeugen eine besondere Rolle spielt.

Gegenüber bereits bekannten Ausführungen kann je nach Anforderung der modulare Stromrichter dem Stromrichtermodul als Grundgerät weitere Funktionen hinzugefügt werden. Dabei hat man den Vorteil, dass nur wenige Anpassungen erforderlich sind. Dadurch werden durch die Erfindung ein geringeres Volumen, geringes Gewicht und geringere Kosten erzielt, da der modulare Stromrichter nur genau die Funktionen enthält, die gefordert werden. Beispielsweise können Gehäuse und Kühlplatte kleiner dimensioniert werden und bleiben unabhängig vom Funktionsumfang gleich. Gerade bei Anpassungen eines Stromrichters für die Anwendung in einem Fahrzeug, wie beispielsweise in einem Bus, kommen gerade die Vorteile in Bezug auf Volumen und Gewicht besonders vorteilhaft zur Geltung, da dort der Einbauraum besonders knapp bemessen ist und eine Gewichtsreduktion sich positiv auf die Umwelteigenschaften (Energieverbrauch) des Fahrzeugs auswirkt.

Bei einer vorteilhaften Ausgestaltung der Erfindung wird die erste Oberfläche durch einen Metallkörper gebildet, wobei der Metallkörper einen Hohlraum für das Durchfließen der Kühlflüssigkeit aufweist. Dieser Metallkörper dient damit dem mit diesem Metallkörper verbundenen DC/DC Steller als Kühlkörper. Ein Kühlkörper für die Flüssigkeitskühlung wird auch als Kühlplatte bezeichnet. Das Metall weist eine relativ hohe Wärmeleitfähigkeit auf, die einen schnellen und guten Wärmeübergang von dem DC/DC Steller zur Kühlflüssigkeit sicherstellt. Darüber hinaus weist der Metallkörper eine hohe Stabilität auf, so dass an diesem der DC/DC Steller auch mechanisch sicher befestigt werden kann. Darüber hinaus ist es aufgrund der Stabilität des Metalls möglich, die Metallschicht zwischen der ersten Oberfläche und der Kühlflüssigkeit besonders dünn, beispielsweise mit einer Dicke von bis zu 3 mm auszuführen, die bei hoher Stabilität einen besonders guten Wärmeübergang zur Kühlflüssigkeit sicherstellt.

Bei einer weiteren vorteilhaften Ausgestaltung der Erfindung ist eine weitere elektrische Komponente, insbesondere ein Kurzschließer, an einer weiteren Oberfläche des Stromrichtermoduls angeordnet. Dadurch wird der modulare Stromrichter auf einfache Art erweiterbar. Dabei kann auch die weitere Oberfläche eine kühlende, d.h. entwärmende, Wirkung erzielen, indem sich der Kanal zumindest abschnittsweise auch auf die Umgebung der weiteren Oberfläche erstreckt. Die Querschnittsfläche des Kanals kann dabei dem Kühlbedarf der weiteren elektrischen Komponente angepasst werden. Ebenso ist es möglich, für die weitere Oberfläche keine kühlende Eigenschaft vorzusehen. Das ist dann vorteilhaft, wenn die elektrische Komponente keine oder nur geringe Verluste erzeugt, die beispielsweise hinreichend über Konvektion abgeführt werden können. Ebenso ist es Möglich, dass Gehäuse an dieser Stelle, d.h. im Bereich der weiteren Oberfläche mit einer hohen thermischen Kapazität auszuführen. Dieser stellt einen Wärmespeicher da, der Wärme aufnimmt. Unter anderem bieten Metalle diese Eigenschaft. Durch die Nähe zum Stromrichtermodul kann für die Ansteuerung der weiteren elektrischen Komponente die Steuer- oder Regelvorrichtung des Stromrichtermoduls genutzt werden. Auch dies erlaubt wieder einen kompakten und leichten Aufbau.

Im Folgenden wird die Erfindung anhand der in den Figuren dargestellten Ausführungsbeispiele näher beschrieben und erläutert. Es zeigen:
- FIG 1: ein Ausführungsbeispiel für ein Stromrichtermodul,
- FIG 2: einen Schnitt durch einen Teil eines Stromrichter-moduls,
- FIG 3: einen modularen Stromrichter und
- FIG 4: ein Fahrzeug mit einem modularen Stromrichter.

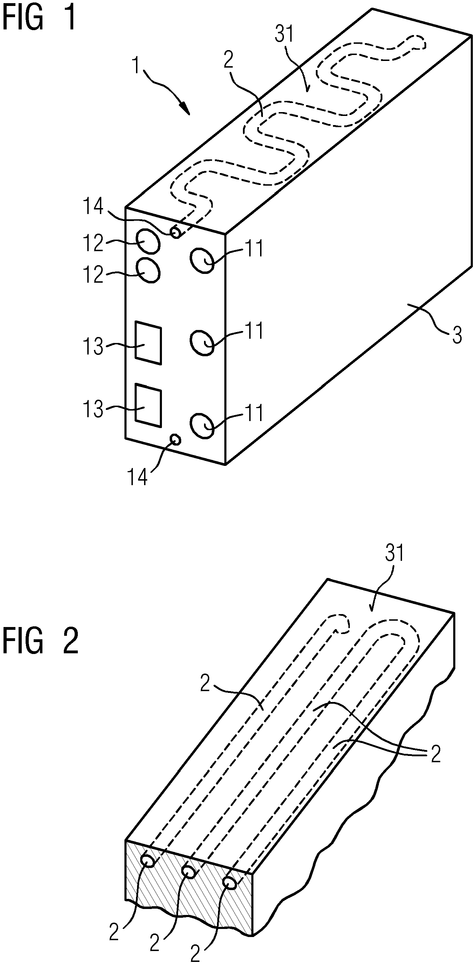

Die FIG 1 zeigt ein Ausführungsbeispiel eines Stromrichtermoduls 1. Dieses Stromrichtermodul 1 weist ein Gehäuse 3 auf, in dem ein nicht näher dargestellter Wechselrichter angeordnet ist. Die Anschlüsse für den Wechselrichters, wie beispielsweise die Wechselspannungsanschlüsse 11, die Gleichspannungsanschlüsse 12, die Steueranschlüsse 13 und die Kühlanschlüsse 14 befinden sich an einer Seite des Gehäuses 3. Alternativ können sich die verschiedenen Anschlüsse auch an unterschiedlichen Seiten des Gehäuses 3 befinden. Das Gehäuse weist eine erste Oberfläche 31 auf, an der ein DC/DC Steller 4 angeordnet und befestigt werden kann. Entlang der ersten Oberfläche 31 erstreckt sich ein Kanal 2 des Kühlsystems, durch den Kühlflüssigkeit strömen kann. Diese Kühlflüssigkeit kühlt die erste Oberfläche 31 und damit den dort angeordneten DC/DC Steller 4. Der Kanal 2 kann dabei in einer vorteilhaften Ausgestaltung sich mäanderförmig entlang der ersten Oberfläche 31 erstrecken, um einen guten Wärmeübergang von der ersten Oberfläche 31 zur Kühlflüssigkeit zu erzielen. Die Kühlflüssigkeit wird auch als Kühlmedium bezeichnet. Alternativ kann der Kanal 2 auch jede andere Ausgestaltung haben. Beispielsweise können wie im Schnitt durch das Stromrichtermodul 1 in FIG 2 dargestellt, sich einzelne Kanäle 2 des Kühlsystems auch parallel entlang der ersten Oberfläche 31 erstrecken. Dabei können zumindest zwei dieser parallelen Kanäle am Ende der ersten Oberfläche 31 wie dargestellt miteinander verbunden sein.

Darüber hinaus ist es vorteilhaft, wenn sich der Kanal 2 nahe der ersten Oberfläche 31 befindet um einen guten Wärmeübergang zwischen einem an der ersten Oberfläche 31 angeordneten DC/DC Steller 4 und dem Kühlmedium, das durch den Kanal 2 strömt, zu erzielen. Je nach Beschaffenheit der ersten Oberfläche 31 beträgt der Abstand des Kanals 2 zur ersten Oberfläche 31 weniger als 1 cm. Insbesondere bei der Ausgestaltung der ersten Oberfläche 31 aus Metall kann aufgrund der hohen Festigkeit der Abstand zwischen Kanal 2 und Oberfläche 31 geringer als 3mm gewählt werden.

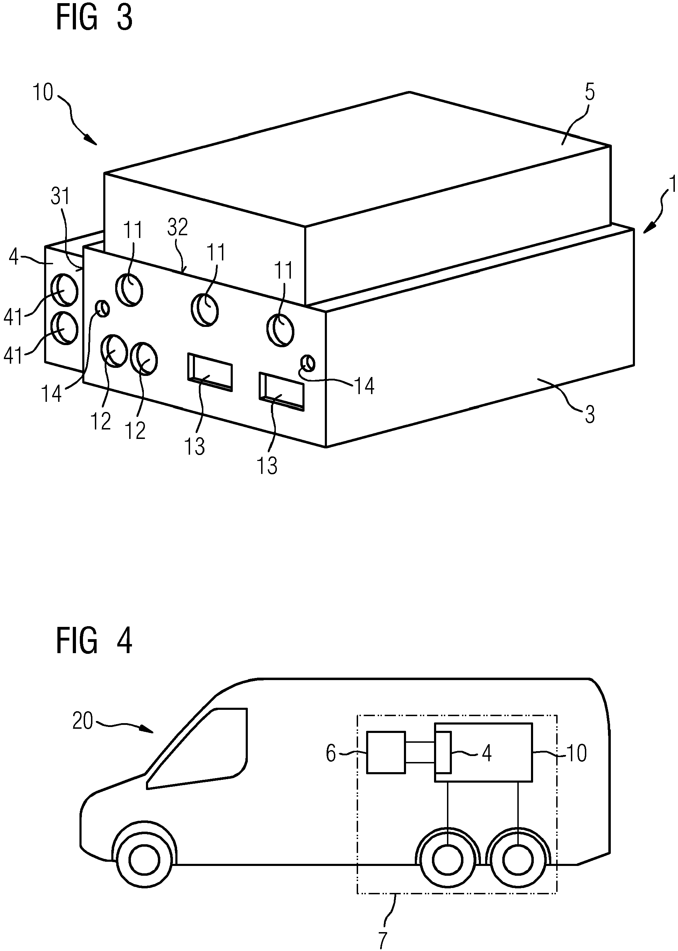

Die FIG 3 zeigt einen modularen Stromrichter 10 der aus einem Stromrichtermodul 1 aufgebaut ist. Auch hier sind die Anschlüsse, wie in der Beschreibung zur FIG 1 bereits aufgezählt, an einer Seite des Gehäuses 3 angeordnet. Darüber hinaus ist an der ersten Oberfläche 31 ein DC/DC Steller 4 angeordnet, der wiederum Gleichspannungsanschlüsse 41 allerdings keine weiteren Kühlanschlüsse aufweist. Weiter ist an einer weiteren Oberfläche 32 des Gehäuses 3 ein Kurzschließer 5 als weitere Komponente angeordnet. Dafür kann sich der Kanal 2 auch zumindest abschnittsweise entlang der weiteren Oberfläche 32 erstrecken. Alternativ kann der Kurzschließer 5 derart konstruiert werden, dass er nicht gekühlt werden muss oder selbst einen Kühlkanal mit weiteren Kühlanschlüssen aufweist, der mit Kühlflüssigkeit durchströmt wird. Alternativ oder ergänzend kann das Gehäuse derart dick an der weiteren Oberfläche 32 ausgeführt sein, dass es eine hohe thermische Kapazität aufweist und damit Wärme aufnehmen und speichern kann. Damit ist das Gehäuse 3 an der Stelle der weiteren Oberfläche dicker als in den übrigen Bereichen des Gehäuses außerhalb der ersten Oberfläche 31. Zum Erreichen der hohen thermischen Kapazität kann anstelle eines dickeren Gehäuses 3 im Bereich der weiteren Oberfläche 32 eine hier nicht dargestellte Metallplatte zwischen weiterer Oberfläche und Kurzschließer 5 angeordnet werden.

Dieser modulare Stromrichter auf Basis des Wechselrichters ist um die Funktionen DC/DC Steller 4 und Kurzschließer 5, insbesondere um die Funktion eines 3-phasigen Kurzschließers, erweitert worden. Das Grundgerät umfasst den Wechselrichter, vorzugsweise als 3phasiger Wechselrichter ausgebildet. In diesem Grundgerät sind die Gleichspannungsanschlüsse 12, die Wechselspannungsanschlüsse 11, die Steuerungsanschlüsse 13 sowie die Kühlanschlüsse 14 für die Flüssigkeitskühlung integriert. Dem Grundgerät kann durch den DC/DC Steller 4 eine 4. Phase, beispielsweise zur Ansteuerung eines Bremswiderstandes oder zur Steuerung eines Energieaustauschs mit einem Energiespeicher, hinzugefügt werden. Ebenso kann durch den Kurzschließer 5 die Sicherheit des Antriebs, insbesondere eines Fahrzeugantriebs, erhöht werden, da sich eine Synchronmaschine einfach und sicher mit Hilfe eines Kurzschließers abbremsen lässt. Diese sichere Bremse ist einfach auch Zulassungsbehörden gegenüber nachweisbar.

Der DC/DC Steller 4 kann den Zwischenkreis des Wechselrichters sowie alternativ oder ergänzend die Steuerung/Regelung des Wechselrichters nutzen. Der Kurzschließer 5 ist weitegehend räumlich getrennt, damit im Fehlerfall durch diese Trennung ein Schutz gegeben ist z.B. bei defektem Halbleiter, insbesondere Leistungshalbleiter, im Wechselrichter. Dabei ist der Kurzschließer vorzugsweise über interne Verbindungen an die Phasen des Wechselrichters angeschlossen. In einer vorteilhaften Ausgestaltung nutzt auch der Kurzschließer 5 die vorhandene Steuerung des Stromrichtermoduls. Das Stromrichtermodul ist dabei das Wechselrichtergrundgerät.

Als Vorteil dieser Anordnung ist zu nennen, dass die Zusatzfunktion des Kurzschließers keine zusätzlichen Anschlüsse erfordert. Ebenso ist es möglich, den Kurzschließer 5 mit einer dicken Bodenplatte derart auszuführen, dass er aufgrund der hohen thermischen Kapazität der Bodenplatte keine Flüssigkeitskühlung benötigt.

Die FIG 4 zeigt ein Fahrzeug 20 mit einem Antrieb 7, der einen modularen Stromrichter 10 aufweist. Dabei wirkt der modulare Stromrichter 10 auf nicht näher dargestellte Motoren, die das Fahrzeug über die Räder antreiben. Elektrische Energie bezieht der modulare Stromrichter 10 beispielsweise aus einer Batterie 6, die mit dem DC/DC Steller 4 des modularen Stromrichters 10 verbunden ist. Der DC/DC Steller 4 kann gesteuert oder geregelt Energie der Batterie 6 entnehmen oder, beispielsweise beim Bremsen, zuführen.

Zusammenfassend betrifft die Erfindung ein Stromrichtermodul mit einem dreiphasigen Wechselrichter und einem Kühlsystem zum Kühlen mit einer Kühlflüssigkeit, wobei das Kühlsystem einen Kanal zum Führen der Kühlflüssigkeit aufweist. Zur Verbesserung der Modularität des flüssigkeitsgekühlten Stromrichters wird vorgeschlagen, dass das Stromrichtermodul ein Gehäuse aufweist und der dreiphasige Wechselrichter im Innern des Gehäuses angeordnet ist, wobei das Gehäuse eine erste Oberfläche aufweist, an der ein DC/DC Steller kontaktierbar ist, wobei der Kanal zum Führen der Kühlflüssigkeit sich derart entlang der ersten Oberfläche erstreckt, dass die erste Oberfläche durch die Kühlflüssigkeit kühlbar ist. Ferner betrifft die Erfindung einen modularen Stromrichter mit einem derartigen Stromrichtermodul und einem DC/DC Steller, wobei der DC/DC Steller an der ersten Oberfläche des Stromrichtermoduls angeordnet ist. Die Erfindung betrifft weiter ein Fahrzeug mit einem derartigen Stromrichtermoduloder einem derartigen modularen Stromrichter, wobei das Stromrichtermodul oder der modulare Stromrichter ein Teil des Antriebs des Fahrzeugs ist. Weiter betrifft die Erfindung ein Verfahren zum Kühlen eines derartigen modularen Stromrichters, wobei die Wärme des DC/DC Stellers über die erste Oberfläche des Stromrichtermoduls an die Kühlflüssigkeit des Kühlsystems des Stromrichtermoduls abgeführt wird.

## Patentansprüche

1. Stromrichtermodul (1), aufweisend:
- einen dreiphasigen Wechselrichter und
- ein Kühlsystem zum Kühlen mit einer Kühlflüssigkeit,
wobei das Kühlsystem einen Kanal (2) zum Führen der Kühlflüssigkeit aufweist, wobei das Stromrichtermodul (1) ein Gehäuse (3) aufweist und der dreiphasige Wechselrichter im Innern des Gehäuses (3) angeordnet ist, wobei das Gehäuse (3) eine erste Oberfläche (31) aufweist, an der ein DC/DC Steller (4) kontaktierbar ist, wobei der Kanal (2) zum Führen der Kühlflüssigkeit sich derart entlang der ersten Oberfläche (31) erstreckt, dass die erste Oberfläche (31) durch die Kühlflüssigkeit kühlbar ist.

2. Stromrichtermodul (1) nach Anspruch 1, wobei die erste Oberfläche (31) durch einen Metallkörper gebildet wird, wobei der Metallkörper einen Hohlraum für das Durchfließen der Kühlflüssigkeit aufweist.

3. Modularer Stromrichter (10) aufweisend
- ein Stromrichtermodul (1) nach einem der Ansprüche 1 oder 2, und
- einen DC/DC Steller (4)
wobei der DC/DC Steller (4) an der ersten Oberfläche (31) des Stromrichtermoduls (1) angeordnet ist.

4. Modularer Stromrichter (10) nach Anspruch 3, wobei eine weitere elektrische Komponente, insbesondere ein Kurzschließer (5), an einer weiteren Oberfläche (32) des Stromrichtermoduls angeordnet ist.

5. Fahrzeug (20) mit einem Stromrichtermodul (1) nach einem der Ansprüche 1 oder 2 oder einem modularen Stromrichter (10) nach einem der Ansprüche 3 oder 4, wobei das Stromrichtermodul (1) oder der modulare Stromrichter (10) ein Teil des Antriebs des Fahrzeugs (20) ist.

6. Verfahren zum Kühlen eines modularen Stromrichters (10) nach einem der Ansprüche 3 oder 4, wobei die Wärme des DC/DC Stellers (4) über die erste Oberfläche (31) des Stromrichtermoduls (1) an die Kühlflüssigkeit des Kühlsystems des Stromrichtermoduls (1) abgeführt wird.
